Europäisches Patentamt

European Patent Office

Office européen des brevets

(19)

(11) EP 1 094 601 A1

(12) **EUROPEAN PATENT APPLICATION**

(43) Date of publication:
25.04.2001 Bulletin 2001/17

(51) Int Cl.⁷: $H03H\ 2/00$, $H01P\ 1/20$

(21) Application number: 99308211.4

(22) Date of filing: 18.10.1999

(84) Designated Contracting States:
**AT BE CH CY DE DK ES FI FR GB GR IE IT LI LU
MC NL PT SE**
Designated Extension States:
**AL LT LV MK RO SI**

(71) Applicant: **LUCENT TECHNOLOGIES INC.
Murray Hill, New Jersey 07974-0636 (US)**

(72) Inventors:
• **Farhat, Abbas
Twickenham TW2 5LU (GB)**
• **Yan, Ran-Hong
Faringdon, SN7 7SS (GB)**

(74) Representative: **Williams, David John et al
Lucent Technologies UK Limited,
5 Mornington Road
Woodford Green, Essex IG8 0TU (GB)**

(54) **Tunable electrical component**

(57)    A tuneable resonator or filter has a layer of ferroelectric material (16) between 2 layers (12, 14) of conducting or high temperature super conducting material, and means to apply a variable DC electric field to the ferroelectric layer. The ferroelectric material may be strontium titanate at a thickness of 140 nanometers, the conducting material may be copper, and the high temperature super conducting material may be YBCO. A filter or resonator with a resonant frequency of the order tens of MHz can be provided, and the resonant frequency can be varied by altering the applied DC field by tens of millivolts.

# FIG. 1a

EP 1 094 601 A1

# FIG. 1b

**Description**

This invention relates to a tunable electrical component such as a resonator or filter.

It is known that ferroelectric materials have a dielectric constant, the value of which can be altered by an externally-applied electrical field, and the application of this property in some electrical components has been described by I B Vendik and L T Ter-Martirosyan, "Use of high-temperature superconducting structures in cooled microwave phase shifter," Technical Physics, 1993, V. 38 (12) December, pp. 1090-1093, and by V K Varadan, D K Ghodgaonkar, V V Varadan, J F Kelly and P Glikerdas, "Ceramic phase shifters for electronically steerable antenna systems," Microwave Journal, January 1992, pp. 116-127 and by C M Jackson, JH Kobayashi, A Z Kain, A Lee, C L Pettiette-Hall, JF Burch and R Hu, "Novel monolithic phase shifter combining ferroelectrics and superconductors," Integrated Ferroelectrics, 1994, vol. 4, pp.121-129..

However, the use of ferroelectric materials in resonators or filters has not previously been disclosed.

According to the invention, a tuneable electrical component comprises first and second layers of conducting or super conducting material, characterised by a layer of ferroelectric material between the first and second layers, and means to apply a DC electrical field of variable magnitude to the first and second layers whereby a resonator or filter is provided which is operable at a frequency which varies in accordance with the applied electrical field.

The invention will now be described by way of example with reference to the accompanying drawings in which:-

Figure 1a is a view of a tuneable component;
Figure 1b is a sectional view of the component;
Figure 2 illustrates phase shift against applied electrical field; and
Figure 3 illustrates computed fractional frequency shift against applied electrical field.

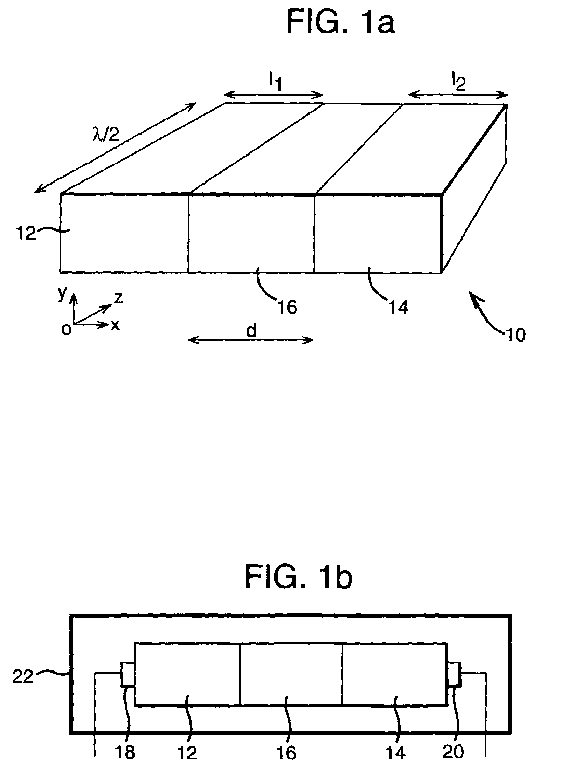

In Figure la a tuneable component 10 comprises first and second layers 12, 14 of a conductor with a layer 16 of ferroelectric material between them. Figure 1b shows that each of the layers 12, 14 is supplied with a radio frequency connector 18, 20, and the component is provided with an enclosure 22. The conducting layers 12, 14 may alternatively be a high temperature superconductor.

The conductor may be copper, the high temperature superconductor may be YBCO, and the ferroelectric may be $SrTiO_3$.

Referring again to Figure la, the thickness of the ferroelectric layer 16 is d, the thickness of the first and second conducting layers are $l_1$ and $l_2$ and the length in the Z direction is $\frac{\lambda}{2}$.

The proportions of the ferroelectric layer 12 and the thicknesses of the conducting layers 14, 16 are such that the dielectric layer 12 can be considered very thick so that electric and magnetic fields in this region can be assumed to decay exponentially from the dielectric/conductor interfaces. The arrangement can be considered as a parallel plate transmission line.

Consider now the application of the two-fluid model for the super conducting layers 12, 14, in which the total current is the sum of the super current and the normal current; the classical skin effect and London theory are assumed for the normal current and the super current respectively. Appropriate formulations are found in the publications by J C Swihart, "Field Solution for a Thin-Film Superconducting Strip Transmission Line", J.Appl. Phys. Vol.32, No.3, March, 1961, pp 461-469, and by Farhat Abbas and L E Davis "Propagation coefficient in a superconducting asymmetrical parallel-plate transmission line with a buffer layer", J. Appl. Phys. Vol. 73, No. 9, 1 May, 1993, pp 4494-4499.

Considering a transverse magnetic wave and applying the formulations of Swihart and Abbas, then

$\alpha$ =        propagation constant along the Z direction (taking $e^{j \alpha z}$)
$\omega$ =        angular frequency (assuming $e^{jwt}$)
$\varepsilon_o$ =        permittivity of vacuum
$\mu_0$ =        permeability of vacuum
$\varepsilon_r$ =        relative permitivity of the ferroelectric layer 16
$\lambda_r$ =        penetration depth of the conductor layers 12,14
$\sigma_r$ =        conductivity of the conductor layers 12,14
$\Delta\emptyset$ =        phase shift
E =        electric field
H =        magnetic field
L =        length of transmission line

The dispersion relation will now be derived, using the formulations of Swihart and Abbas.

$$\overline{H_y} = \frac{1}{\alpha \mu_0 \omega} \left( \alpha^2 - \kappa^2 \right) \overline{E_x}$$

$$\overline{E_z} = -\frac{\iota}{\alpha} \frac{d\overline{E_x}}{dx}$$

$$\frac{d^2 \overline{E_x}}{dx^2} - \kappa^2 \overline{E_x} = 0 \tag{1}$$

where, for the dielectrics,

$$\kappa^2 \underset{=}{\Delta} K_r = \alpha^2 - \omega^2 \varepsilon_r \mu_0 \qquad r = 1,2 \tag{2}$$

while for the normal

$$\kappa^2 \underset{=}{\Delta} \kappa_r = \alpha^2 - \omega^2 \varepsilon_0 \mu_0 + \iota \omega \mu_0 \sigma_r \qquad r = 1, 2 \tag{3a}$$

and/or superconductors

$$\kappa^2 \underset{=}{\Delta} \kappa_r = \frac{1}{\lambda_r^2} + \alpha^2 - \omega^2 \varepsilon_0 \mu_0 + \iota \omega \mu_0 \sigma_r \qquad r = 1, 2. \tag{3b}$$

The second order differential equation (1) has two independent solutions of the form $e^{\kappa x}$ and $e^{-\kappa x}$, where $\kappa$ is taken to be the root of $\kappa^2$ with positive real part. In dielectric 1 (layer 16 in Fig. 1.) in the positive x-direction taking only the solution $e^{-K_1 x}$, and in negative x-direction taking only the solution $e^{K_1 x}$, discarding $e^{K_1 x}$ for the positive x direction and $e^{-K_1 x}$, for the negative x direction. In conducting layers 12, 14 and in the dielectric layer 16 both solutions are needed in order to satisfy the boundary conditions.

The solutions defined above for each medium give eight arbitrary constants for the amplitudes of the fields (one in each dielectric layer 16, two in each conducting layer 12,14 and in the dielectric layer 16. There are eight boundary conditions that must be satisfied, namely, the continuity of the tangential fields $\overline{E_z}$ and $\overline{H_y}$ at the four boundaries shown in figure 1. By ignoring non-linearity of the system, only seven of the constants can be determined in terms of the eighth by using seven of the eight boundary conditions. That is, the characteristics of the line are independent of the amplitude of the wave. The eighth boundary condition gives an equation for the propagation constant $\alpha$ which must be satisfied in order for a solution to exist.

Using the same approach as that of Abbas, this condition can be expressed for a lossless structure as follows

$$\alpha^2 = \omega^2 \mu_0 \varepsilon_0 \varepsilon_2 \left[ 1 + \frac{\lambda_1}{d} \coth\left(\frac{l_1}{\lambda_1}\right) + \frac{\lambda_2}{d} \coth\left(\frac{l_2}{\lambda_2}\right) \right]. \tag{4}$$

The phase velocity can be written as

$$v \underset{=}{\Delta} \frac{\omega}{\Re(\alpha_2)},$$

$$v = \frac{1}{\sqrt{\mu_0 \varepsilon_0 \varepsilon_2 \left[ 1 + \frac{\lambda_1}{d} \coth\left(\frac{l_1}{\lambda_1}\right) + \frac{\lambda_2}{d} \coth\left(\frac{l_2}{\lambda 2}\right) \right]}} \cdot \quad (5)$$

The tuneable microwave components based on dielectric nonlinearity by using metal/ferroelectric/metal thin-films shown in figure 1 can be described by the penetration depth $\lambda_r$ and the normal conductivity $\sigma r$ of the normal and/or superconductors, the dielectric constant $\varepsilon r$ of the dielectric, and the thicknesses d and $1_r$ of the dielectric and the normal and/or superconductors.

Nonlinearity of the dielectric constant $\varepsilon 2$ due to the variations of the dc bias electric field E (KV/cm) has to be approximated by E Sawaguchi, A Kikuchi and Y Kodera, "Dielectric constant of strontium titanate at low temperatures", J. Phys. Soc. Japan, 17 (1962), 1666-1667, and by J F Scott, "Ferroelectric memories", Physics World February 1995, pp 46-50 and references therein and is given as:

$$\varepsilon_2 = -429 E^2 + 12992 \quad (6)$$

Equation (6) is obtained by using the MATLAB polyfit routine which fits the data of Sawaguchi, in a least-squares sense.

It has now been realised that, using equation (4) the expression for the phase shift can be derived as:-

$$\Delta\phi = L\omega\sqrt{\mu_0 \varepsilon_0} \left[ \sqrt{\varepsilon_2(E=0)} - \sqrt{\varepsilon_2(E)} \right] \sqrt{\mu_0 \varepsilon_0 \varepsilon_2 \left[ 1 + \frac{\lambda_1}{d} \coth\left(\frac{l_1}{\lambda_1}\right) + \frac{\lambda_2}{d} \coth\left(\frac{l_2}{\lambda 2}\right) \right]} \cdot \quad (7)$$

Consider now the application of the equations to a transmission line in which the super conductor is YBCO and the ferroelectric is strontium titanate. The perameters for these materials are available from the references given above. The penetration depth used for the high quality thin film of YBCO is 140 nanometers.

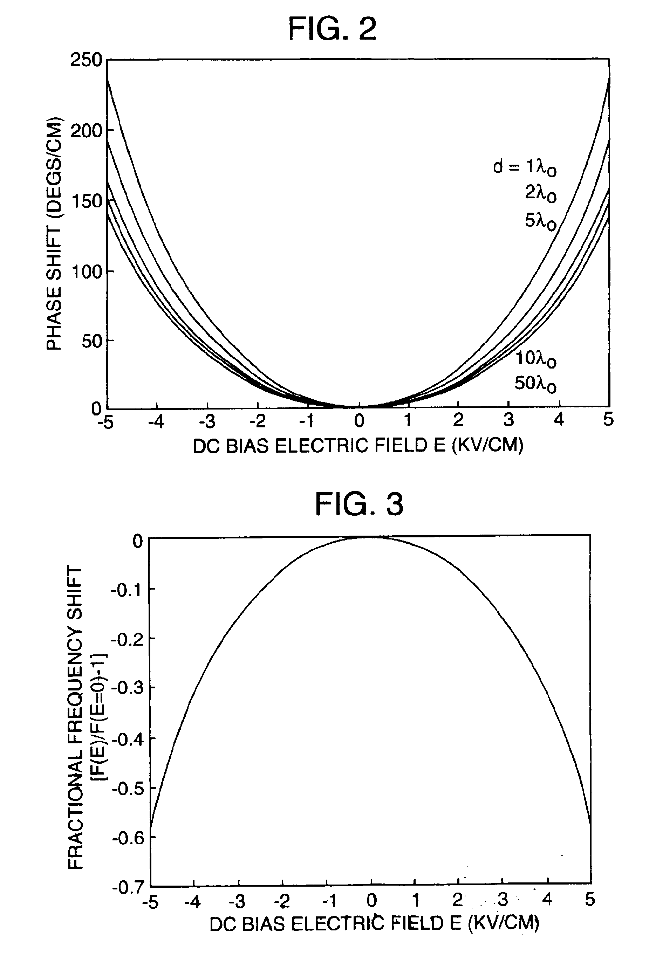

Figure 2 is a plot of phase shift in degrees per centimetre against DC bias electric field in kilovolts per centimetre for different separations $\lambda_0$ /d =1, 2, 5, 10 and 50, for identical infinite super conducting planes at $T/T_c$ =0.05.

Inspection of Figure 2 shows that the thinner ferroelectric material gives greater tunability, that is a greater phase shift. From the form of the structure shown in Figure la, the resonant frequency F of the component is proportional to the phase velocity. It is therefore convenient to investigate a quantity F(t)/F(t=0)-1, and this will be referred to as a fractional frequency shift. Figure 3 is a plot of computed fractional frequency shift against DC bias electric field in kilovolts per centimetre, and it can be seen that for a ferroelectric layer 16 of thickness 140 nanometres, resonant frequencies of the order of tens of MHz per centimetre can be tuned by variations of tens of milivolts.

By use of the invention, a tuneable filter or resonator can therefore be provided having a frequency range which is selectable for a particular application. Such a filter may be used in a radio telecommunications system, in which a single filter operable at different selectable frequencies will provide considerable cost savings over the need to provide a filter for each required frequency. Such a filter may be used, for example, in the base stations of GSM (Global System for Mobile Communications).

In any application, a single filter according to the invention may have insufficiently close approximation to a square-wave cut-off characteristic, but the use of two or more filters in series will provided an improved approximation.

**Claims**

1. A tuneable electrical component comprising first and second layers (12, 14) of conducting or super conducting material, characterised by a layer (16) of ferroelectric material between the first and second layers, and means (18, 20) to apply a DC electrical field of variable magnitude to the first and second layers, whereby a resonator or filter is provided which is operable at a frequency which varies in accordance with the applied electric field.

**2.** A component according to Claim 1 in which the ferroelectric material is strontium titanate.

**3.** A component according to Claim 1 or Claim 2 in which the ferroelectric material is between 100 and 200 nanometres thick.

**4.** A component according to Claim 3 in which the ferroelectric material is 140 nanometers thick.

**5.** A component according to any preceding claim in which the electrical field is variable between -5 and +5 kilovolts per centimetre thickness of the ferroelectric material.

**6.** A component according to any preceding claim in which the resonant frequency of the resonator or filter is of the order tens of MHz and the magnitude of the electric field is variable by tens of millivolts.

**7.** A component according to any preceding claim in which the first and second layers (12, 14) are made of copper.

**8.** A component according to any one of Claims 1 to 6 in which the first and second layers (12, 14) are made of YBCO.

# FIG. 1a

# FIG. 1b

# FIG. 2

# FIG. 3

**European Patent Office**

**EUROPEAN SEARCH REPORT**

Application Number

EP 99 30 8211

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | WO 94 13028 A (SUPERCONDUCTING CORE TECHNOLOG ;UNIV RESEARCH CORP (US)) 9 June 1994 (1994-06-09) | 1,2 | H03H2/00 H01P1/20 |
| A | * page 6, line 4-19 * <br> * page 7, line 8-16 * <br> * page 9, line 14-26 * <br> * page 16, line 5-14; figure 1 * <br> * page 28, line 1 - page 29, line 12; figures 21,22,25 * <br> ----- | 3-5,8 | |

TECHNICAL FIELDS SEARCHED (Int.Cl.7)

H03H
H01P

The present search report has been drawn up for all claims

| Place of search | Date of completion of the search | Examiner |
|---|---|---|
| THE HAGUE | 22 March 2000 | Coppieters, C |

EPO FORM 1503 03.82 (P04C01)

**ANNEX TO THE EUROPEAN SEARCH REPORT
ON EUROPEAN PATENT APPLICATION NO.**                    EP 99 30 8211

This annex lists the patent family members relating to the patent documents cited in the above-mentioned European search report.
The members are as contained in the European Patent Office EDP file on
The European Patent Office is in no way liable for these particulars which are merely given for the purpose of information.

22-03-2000

| Patent document cited in search report | Publication date | Patent family member(s) | | Publication date |
|---|---|---|---|---|
| WO 9413028 A | 09-06-1994 | US | 5472935 A | 05-12-1995 |
| | | AU | 680866 B | 14-08-1997 |
| | | AU | 5897394 A | 22-06-1994 |
| | | CA | 2150690 A | 09-06-1994 |
| | | EP | 0672308 A | 20-09-1995 |
| | | FI | 953834 A | 14-08-1995 |
| | | JP | 8509103 T | 24-09-1996 |
| | | US | 5694134 A | 02-12-1997 |
| | | US | 5721194 A | 24-02-1998 |
| | | US | 5589845 A | 31-12-1996 |

EPO FORM P0459

For more details about this annex : see Official Journal of the European Patent Office, No. 12/82